(19) Europäisches Patentamt / European Patent Office / Office européen des brevets

(11) **EP 4 429 116 A1**

(12) **EUROPEAN PATENT APPLICATION**
published in accordance with Art. 153(4) EPC

(43) Date of publication:
**11.09.2024 Bulletin 2024/37**

(21) Application number: **21965945.5**

(22) Date of filing: **30.11.2021**

(51) International Patent Classification (IPC):
*H03L 7/00* (2006.01)    *H04W 52/00* (2009.01)

(52) Cooperative Patent Classification (CPC):
**H03L 7/00; H04W 52/00**

(86) International application number:
**PCT/CN2021/134619**

(87) International publication number:
**WO 2023/097508 (08.06.2023 Gazette 2023/23)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Huawei Technologies Co., Ltd.
Shenzhen, Guangdong 518129 (CN)**

(72) Inventors:
• **GAO, Peng**
  **Shenzhen, Guangdong 518129 (CN)**
• **MAO, Yihong**
  **Shenzhen, Guangdong 518129 (CN)**
• **TIAN, Hongliang**
  **Shenzhen, Guangdong 518129 (CN)**

(74) Representative: **Körber, Martin Hans
Mitscherlich PartmbB
Patent- und Rechtsanwälte
Karlstraße 7
80333 München (DE)**

(54) **PHASE-LOCKED LOOP, RADIO FREQUENCY TRANSCEIVER, AND COMMUNICATION DEVICE**

(57) This application provides a phase-locked loop, a radio frequency transceiver, and a communication device, and relates to the field of communication technologies, to reduce power consumption of the communication device in a discontinuous working scenario. The phase-locked loop is configured to: output a first local oscillator signal in a first time period, where a phase of the first local oscillator signal at an end moment of the first time period is a first phase; disable the first local oscillator signal in a second time period; and output a second local oscillator signal in a third time period. The first time period, the second time period, and the third time period are three consecutive time periods in sequence, an angular frequency of the second local oscillator signal is the same as that of the first local oscillator signal, a phase of the second local oscillator signal at a start moment of the third time period is a second phase, a phase difference between the second phase and the first phase is equal to a product of the angular frequency and a time difference, and the time difference is a difference between the start moment of the third time period and the end moment of the first time period. The phase-locked loop is used in the communication device, to reduce power consumption of the communication device in the discontinuous working scenario.

FIG. 5

## Description

### TECHNICAL FIELD

This application relates to the field of communication technologies, and in particular, to a phase-locked loop, a radio frequency transceiver, and a communication device.

### BACKGROUND

In a wireless communication technology, especially in fifth-generation mobile communication, power consumption of a wireless communication device becomes a main technical problem that needs to be resolved. Therefore, how to meet different working scenarios in a communication standard and optimize a working mode of a communication device to reduce power consumption of the communication device is a main challenge at present.

### SUMMARY

This application provides a phase-locked loop, a radio frequency transceiver, and a communication device, to reduce power consumption of the communication device in a discontinuous working scenario.

To achieve the foregoing objective, the following technical solutions are used in embodiments of this application.

According to a first aspect, a phase-locked loop is provided. The phase-locked loop is configured to: output a first local oscillator signal in a first time period, where a phase of the first local oscillator signal at an end moment of the first time period is a first phase; disable the first local oscillator signal in a second time period; and output a second local oscillator signal in a third time period. The first time period, the second time period, and the third time period are three consecutive time periods in sequence, an angular frequency of the second local oscillator signal is the same as that of the first local oscillator signal, a phase of the second local oscillator signal at a start moment of the third time period is a second phase, a phase difference between the second phase and the first phase is equal to a product of the angular frequency and a time difference, and the time difference is a difference between the start moment of the third time period and the end moment of the first time period.

In the foregoing technical solution, the first time period, the second time period, and the third time period are three consecutive time periods in sequence. The phase-locked loop outputs the first local oscillator signal in the first time period, and outputs the second local oscillator signal in the third time period. The phase difference between the second phase of the second local oscillator signal and the first phase of the first local oscillator signal is equal to the product of the angular frequency and the time difference, so as to ensure that initial phases of the local oscillator signals of the phase-locked loop in a discontinuous working scenario are the same. In addition, because the phase-locked loop does not output a local oscillator signal in the second time period, power consumption is low. Therefore, when the phase-locked loop is used in a communication device, power consumption of the communication device can be reduced, and channel consistency of the communication device is implemented.

In a possible implementation of the first aspect, time intervals of the first time period, the second time period, and the third time period are one or more timeslots or short timeslots. In the foregoing possible implementation, initial phases of local oscillator signals of the phase-locked loop in a plurality of consecutive timeslots or short timeslots are the same, and power consumption is low.

In a possible implementation of the first aspect, the timeslot includes 14 symbols or 12 symbols, and the short timeslot includes seven symbols, six symbols, or two symbols. In the foregoing possible implementation, several possible quantities of symbols included in a timeslot and a short timeslot are provided. When the phase-locked loop works in the plurality of inconsecutive timeslots or short timeslots, resource scheduling precision can be improved.

In a possible implementation of the first aspect, the phase-locked loop includes a clock control circuit and a local oscillator signal output circuit. The clock control circuit is configured to output a frequency control word based on a reference clock and a feedback clock. The feedback clock is configured to separately feed back the first local oscillator signal and the second local oscillator signal. The local oscillator signal output circuit is configured to separately output the first local oscillator signal and the second local oscillator signal based on the frequency control word and the reference clock. The local oscillator signal output circuit does not work in the second time period. In the foregoing possible implementation, the clock control circuit always outputs the frequency control word in the three time periods, and the local oscillator signal output circuit outputs the local oscillator signal only in the first time period and the third time period based on the frequency control word, so that the initial phases of the local oscillator signals generated by the phase-locked loop in the discontinuous working scenario are the same, and the local oscillator signal output circuit does not work in the second time period, thereby reducing power consumption.

In a possible implementation of the first aspect, the clock control circuit includes a clock selector and a Sigam-Delta modulator. The clock selector is configured to select one of the feedback clock and the reference clock for output to the Sigam-Delta modulator. The Sigam-Delta modulator is configured to output the frequency control word based on the feedback clock and the reference clock. In the foregoing possible implementation, the initial phases of the local oscillator signals generated by the phase-locked loop in the discontinuous working scenario can be the same, and power consumption is low.

In a possible implementation of the first aspect, the local oscillator signal output circuit includes: a phase detector, a loop controller, and a controllable oscillator that are sequentially coupled in series between a first node and a second node, and a feedback frequency divider that is coupled between the first node and the second node. The first node is coupled to an input end of the local oscillator signal output circuit, and the second node is coupled to an output end of the local oscillator signal output circuit. Optionally, the local oscillator signal output circuit further includes a local oscillator generator coupled between the second node and the output end. In the foregoing possible implementation, a simple and effective local oscillator signal output circuit is provided.

In a possible implementation of the first aspect, the phase-locked loop is a digital phase-locked loop. Optionally, the phase detector includes a time-to-digital converter, the loop controller includes a digital loop controller, and the controllable oscillator includes a digital controlled oscillator. In the foregoing possible implementation, a simple and effective digital phase-locked loop is provided. The initial phases of the local oscillator signals generated by the digital phase-locked loop in the discontinuous working scenario are the same, and power consumption is low.

In a possible implementation of the first aspect, the phase-locked loop is an analog phase-locked loop. Optionally, the phase detector includes a phase-frequency detector and a charge pump, the loop controller includes an analog loop controller, and the controllable oscillator includes a voltage controlled oscillator. In the foregoing possible implementation, a simple and effective analog phase-locked loop is provided. The initial phases of the local oscillator signals generated by the analog phase-locked loop in the discontinuous working scenario are the same, and power consumption is low.

According to a second aspect, a phase-locked loop is provided. The phase-locked loop includes: a phase detector, a loop controller, a controllable oscillator, a local oscillator generator, a feedback frequency divider, and a clock control circuit. An output end of the phase detector is coupled to an input end of the loop controller, an output end of the loop controller is coupled to an input end of the controllable oscillator, an output end of the controllable oscillator is coupled to an input end of the local oscillator generator, and an output end of the local oscillator generator is used as an output end of the phase-locked loop. A first input end of the feedback frequency divider is coupled to a first node, the first node is a coupling point of the controllable oscillator and the local oscillator generator, a second input end of the feedback frequency divider is coupled to an output end of the clock control circuit, an output end of the feedback frequency divider, an input end of the phase detector, and an input end of the clock control circuit are coupled, and another input end of the clock control circuit and another end of the phase detector are coupled to serve as an input end of the phase-locked loop, and may be configured to receive a reference clock.

In a possible implementation of the second aspect, the clock control circuit includes a clock selector and a Sigam-Delta modulator. Two input ends of the clock selector are respectively used as two input ends of the clock control circuit, an output end of the clock selector is coupled to an input end of the Sigam-Delta modulator, and an output end of the Sigam-Delta modulator is used as the output end of the clock control circuit.

In a possible implementation of the second aspect, the clock selector is configured to select one of a feedback clock and the reference clock for output to the Sigam-Delta modulator, and the Sigam-Delta modulator is configured to output a frequency control word based on the feedback clock or the reference clock.

In a possible implementation of the second aspect, a first time period, a second time period, and a third time period are three consecutive time periods in sequence, and the clock selector is configured to select the feedback clock in the first time period and the third time period for output to the Sigam-Delta modulator, and select the reference clock in the second time period for output to the Sigam-Delta modulator. The Sigam-Delta modulator is configured to output the frequency control word based on the feedback clock in the first time period and the third time period, and output the frequency control word based on the reference clock in the second time period. In the second time period, the phase detector, the loop controller, the controllable oscillator, the local oscillator generator, and the feedback frequency divider are turned off.

In a possible implementation of the second aspect, the phase-locked loop is a digital phase-locked loop. Optionally, the phase detector includes a time-to-digital converter, the loop controller includes a digital loop controller, and the controllable oscillator includes a digital controlled oscillator.

In a possible implementation of the second aspect, the phase-locked loop is a digital phase-locked loop. Optionally, the phase detector includes a time-to-digital converter, the loop controller includes a digital loop controller, and the controllable oscillator includes a digital controlled oscillator.

According to a third aspect, a radio frequency transceiver is provided. The radio frequency transceiver includes a transmitter. The transmitter includes a digital-to-analog converter, a first analog processing circuit, a radio frequency modulator, a first phase-locked loop, and an amplifier. An output end of the digital-to-analog converter is coupled to an input end of the first analog processing circuit, an output end of the first analog processing circuit and an output end of the first phase-locked loop are respectively coupled to two input ends of the radio frequency modulator, and an output end of the radio frequency modulator is coupled to an input end of the amplifier. The first phase-locked loop is the phase-locked loop provided in the first aspect, the second aspect, or any one of the foregoing possible implementations.

In a possible implementation of the third aspect, the transmitter transmits a signal in a first time period and a third time period, and disables signal transmission in a second time period.

In a possible implementation of the third aspect, the radio frequency transceiver further includes a receiver. The receiver includes an analog-to-digital converter, a second analog processing circuit, a mixer, a second phase-locked loop, and a low noise amplifier. An output end of the low noise amplifier and an output end of the second phase-locked loop are coupled to two input ends of the mixer, an output end of the mixer is coupled to an input end of the second analog processing circuit, and an output end of the second analog processing circuit is coupled to an input end of the analog-to-digital converter. The second phase-locked loop is the phase-locked loop provided in any one of the first aspect or the possible implementations of the first aspect.

According to a fourth aspect, a communication device is provided. The communication device includes a baseband circuit, a radio frequency transceiver, and an antenna that are sequentially coupled, and the radio frequency transceiver is the radio frequency transceiver provided in any one of the third aspect or the possible implementations of the third aspect.

According to a fifth aspect, a local oscillator signal output method is provided. The method includes: outputting a first local oscillator signal in a first time period, where a phase of the first local oscillator signal at an end moment of the first time period is a first phase; disabling the first local oscillator signal in a second time period; and outputting a second local oscillator signal in a third time period. The first time period, the second time period, and the third time period are three consecutive time periods in sequence, an angular frequency of the second local oscillator signal is the same as that of the first local oscillator signal, a phase of the second local oscillator signal at a start moment of the third time period is a second phase, a phase difference between the second phase and the first phase is equal to a product of the angular frequency and a time difference, and the time difference is a difference between the start moment of the third time period and the end moment of the first time period.

In a possible implementation of the fifth aspect, time intervals of the first time period, the second time period, and the third time period are one or more timeslots or short timeslots.

In a possible implementation of the fifth aspect, the timeslot includes 14 symbols or 12 symbols.

In a possible implementation of the fifth aspect, the short timeslot includes seven symbols, six symbols, or two symbols.

In a possible implementation of the fifth aspect, the phase-locked loop includes a clock control circuit and a local oscillator signal output circuit, and the method further includes: The clock control circuit outputs a frequency control word based on a reference clock and a feedback clock. The local oscillator signal output circuit separately outputs the first local oscillator signal and the second local oscillator signal based on the frequency control word and the reference clock. The local oscillator signal output circuit does not work in the second time period.

In a possible implementation of the fifth aspect, the clock control circuit includes a clock selector and a Sigam-Delta modulator, and that the clock control circuit outputs a frequency control word based on a reference clock and a feedback clock includes: The clock selector selects one of the feedback clock and the reference clock for output to the Sigam-Delta modulator. The Sigam-Delta modulator outputs the frequency control word based on the feedback clock and the reference clock.

It may be understood that any one of the phase-locked loop, the radio frequency transceiver, the communication device, and the method provided above includes content of the phase-locked loop provided above. Therefore, for beneficial effects that can be achieved by the phase-locked loop, the radio frequency transceiver, the communication device, and the method, refer to the beneficial effects of the phase-locked loop provided above. Details are not described herein again.

**BRIEF DESCRIPTION OF DRAWINGS**

FIG. 1 is a schematic diagram of a state of a phase-locked loop in a discontinuous working scenario;
FIG. 2 is a schematic diagram of a discontinuous working scenario;
FIG. 3 is a schematic diagram of another discontinuous working scenario;
FIG. 4 is a schematic diagram of a structure of a radio frequency transceiver according to an embodiment of this application;
FIG. 5 is a schematic diagram of a state of a phase-locked loop in a discontinuous working scenario according to an embodiment of this application;
FIG. 6 is a schematic diagram of a structure of a phase-locked loop according to an embodiment of this application;
FIG. 7 is a schematic diagram of a structure of another first phase-locked loop according to an embodiment of this application;

FIG. 8 is a schematic diagram of a phase-locked loop in a working mode according to an embodiment of this application;

FIG. 9 is a schematic diagram of a phase-locked loop in another working mode according to an embodiment of this application;

FIG. 10 is a time sequence diagram of different signals in a phase-locked loop according to an embodiment of this application;

FIG. 11 is a schematic diagram of a structure of a digital phase-locked loop according to an embodiment of this application; and

FIG. 12 is a schematic diagram of a structure of an analog phase-locked loop according to an embodiment of this application.

## DESCRIPTION OF EMBODIMENTS

The making and use of embodiments are discussed in detail below. It should be understood, however, that a plurality of applicable inventive concepts provided in this application may be implemented in a plurality of specific environments. The specific embodiments discussed are merely illustrative of specific ways to implement and use this description and this technology, and do not limit the scope of this application.

Unless otherwise defined, all technical terms used herein have the same meaning as those commonly known to a person of ordinary skill in the art.

The circuits or other components may be described as or referred to as "configured to" perform one or more tasks. In this case, the term "configured to" is used for implying a structure by indicating that a circuit/component includes a structure (for example, a circuit system) that performs one or more tasks during operation. Therefore, even when a specified circuit/component is currently not operable (for example, not enabled), the circuit/component may also be referred to as being configured to perform the task. Circuits/components used in conjunction with the "configured to" phrase include hardware, for example, a circuit for performing an operation.

Technical solution in embodiments of this application is described below with reference to the accompanying drawings in embodiments of this application. In this application, "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. "At least one of the following items (pieces)" or a similar expression thereof refers to any combination of these items, including any combination of singular items (pieces) or plural items (pieces). For example, at least one item (piece) of a, b, or c may represent: a, b, c, a and b, a and c, b and c, or a, b, and c, where a, b, and c may be singular or plural.

In embodiments of this application, words such as "first" and "second" are used to distinguish between objects with similar names, functions or effects. A person skilled in the art may understand that the words such as "first" and "second" do not limit a quantity and an execution sequence. The term "coupling" is used to represent an electrical connection, including a direct connection by using a wire or a connection end or an indirect connection by using another device. Therefore, "coupling" should be considered as a generalized electronic communication connection.

It should be noted that, in this application, terms such as "example" or "for example" are used to represent giving an example, an illustration, or a description. Any embodiment or design scheme described as "example" or "for example" in this application should not be explained as being more preferred or having more advantages than another embodiment or design scheme. To be precise, the terms such as "example" or "for example" are intended to present a related concept in a specific manner.

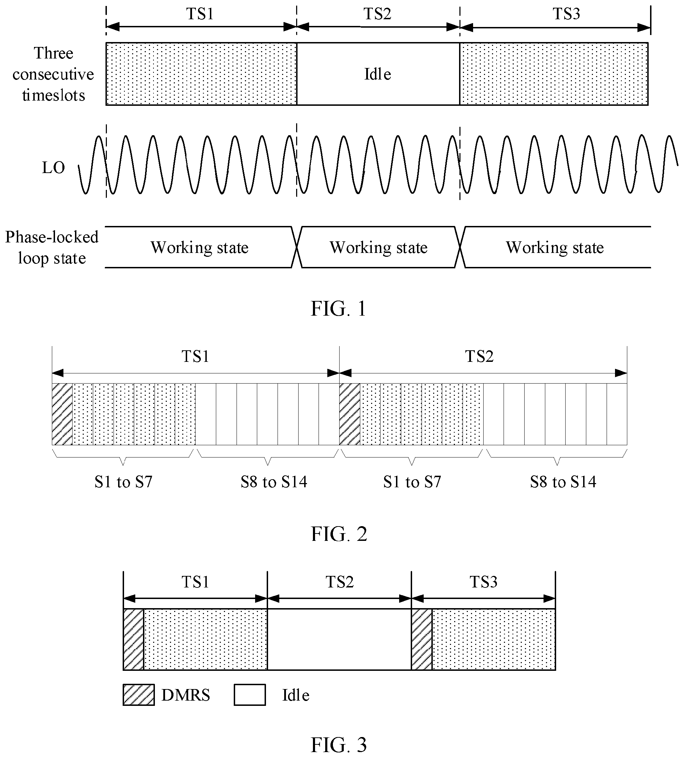

In a cellular communication standard, a plurality of discontinuous working scenarios are defined, that is, a plurality of receiving operations or a plurality of sending operations of a communication device in the discontinuous working scenarios are not consecutive, and there is a specific idle time period. For example, as shown in FIG. 1, three consecutive timeslots (time slots, TS) are classified into a TS1, a TS2, and a TS3. A communication device in a discontinuous working scenario may send service data in the TS1 and the TS3, and is in an idle state in the TS2.

The technical solutions provided in this application may be applied to a communication device that includes a phase-locked loop and supports a discontinuous working scenario. The communication device may be a base station and a terminal device. The communication device that supports the discontinuous working scenario may mean that the communication device may be in the discontinuous working scenario, a plurality of receiving operations or a plurality of sending operations of the communication device in the discontinuous working scenario are not consecutive, and there is a specific idle time period. The following uses the cellular communication standard as an example to describe two discontinuous working scenarios in 5G NR communication.

A first type is a discontinuous working scenario based on symbol-based scheduling (symbol-based scheduling).

In the 5G NR communication standard, to adapt to different application scenarios, scheduling of time-frequency resources at a physical layer is quite flexible. In terms of scheduling of time domain resources, a system defines symbol-based scheduling at a finer granularity than conventional timeslot-based scheduling (slot-based scheduling). The symbol-based scheduling may also be referred to as short timeslot (mini-slot) scheduling. The symbol-based scheduling allows, in one timeslot, only some symbols to be called to transmit service data and the other symbols to be idle. The symbol-level scheduling method can save time domain resources. In addition, for a communication scenario in which ultra-reliable and low-latency communication (ultra-reliable and low-latency communication, URLLC) has a high requirement on a latency, sampling symbol-level scheduling further helps reduce a latency of processing service data.

For example, FIG. 2 is a schematic diagram of a structure of a downlink data frame of a terminal device. The terminal device sequentially receives signals in two timeslots (time slots, TS). The two timeslots are represented as a TS1 and a TS2, each timeslot includes 14 symbols (symbols, S), and the 14 symbols are represented as an S1 to an S14. In each slot, service data is transmitted on the symbols S1 to S7, and the symbols S8 to S14 are set to be in an idle state. In other words, the terminal device performs a receiving operation in a time period of the symbols S 1 to S7 in each timeslot, and does not need to perform a receiving operation in a time period of the symbols S8 to S 14.

It should be noted that in FIG. 2, an example in which each timeslot includes 14 symbols is used to describe an application scenario of symbol-based scheduling. FIG. 2 does not constitute a limitation on embodiments of this application. During actual application, the terminal device may alternatively use a downlink data frame in another format. For example, each timeslot may include 12 symbols, or each short timeslot may include seven symbols or only two symbols. This is not specifically limited in embodiments of this application.

A second type is a discontinuous working scenario based on uplink coverage enhancement (UL coverage enhance).

The uplink coverage enhancement means that a receiving end performs joint estimation by using demodulation reference signals (demodulation reference signal, DMRS) of a plurality of uplink timeslots, to improve reliability of accessing a network by the terminal device in an area with a weak signal, such as a cell edge. In an uplink coverage enhancement scenario, DMRSs used for joint estimation may be allocated to a plurality of inconsecutive timeslots. For example, as shown in FIG. 3, in three consecutive timeslots respectively represented as a TS1 to a TS3, DMRS signals used for uplink coverage enhancement are respectively located in the TS1 and the TS3, the TS1 and the TS3 are inconsecutive, and the TS2 located between the TS1 and the TS3 is an idle (idle) time period.

In the foregoing two working scenarios, transmission of service data is not continuous, that is, an idle state exists between transmission of a plurality of segments of service data. Similarly, the communication device usually has a specific requirement on consistency of communication channels, that is, channels in a valid communication time period are required to be consistent, and insertion of an idle time period should not affect the consistency of the channels. For the symbol-based scheduling shown in the first working scenario, in two time periods: the valid symbols S1 to S7 in the TS1 and the valid symbols S 1 to S7 in the TS2, it should be ensured that transmission channels of signals are consistent. In this way, the terminal device can be prevented from performing channel estimation on each segment of transmission signal, thereby reducing a load caused by a channel estimation operation. For the uplink coverage enhancement shown in the second working scenario, when the DMRS is sent in the TS1 and the DMRS is sent in the TS3, end locations of a transmitting end should present a same channel characteristic, to ensure correlation between DMRSs sent in a plurality of timeslots, thereby improving effectiveness of uplink joint estimation.

For the discontinuous working scenario, it is required that channels of the communication device in an effective communication time period are consistent, that is, insertion of an idle time period should not affect channel consistency. In the communication device, a radio frequency transceiver (transceiver, TCVR) is a key link for determining a channel characteristic. It is required that channels of the communication device are consistent, and it needs to be ensured that an initial phase of a local oscillator signal provided by the radio frequency transceiver does not change in an entire communication process. Currently, a method for maintaining an initial phase of a local oscillator signal is specifically: ensuring that a phase-locked loop that provides the local oscillator signal is always in a stable working state in an entire communication process, so as to maintain the initial phase of the local oscillator signal by maintaining the working state of the phase-locked loop. For example, as shown in FIG. 1, when the radio frequency transceiver sends service data in the TS1 and the TS3 and is in an idle state in the TS2, a phase-locked loop in the radio frequency transceiver is always in a working state within the time period of the TS1 to the TS3, that is, the phase-locked loop continuously outputs a local oscillator signal LO within the time period of the TS1 to the TS3. However, when the communication device in the discontinuous working scenario enters an idle state, the communication device does not perform a sending or receiving operation. In this case, keeping the phase-locked loop in a stable working state causes large power consumption. The following uses a structure of a radio frequency transceiver as an example for description.

A main function of the radio frequency transceiver is to implement frequency change of a signal between a baseband and a radio frequency, and perform operations such as amplification and filtering on the signal. The following uses a zero intermediate frequency radio frequency transceiver as an example to describe a structure of the radio frequency transceiver.

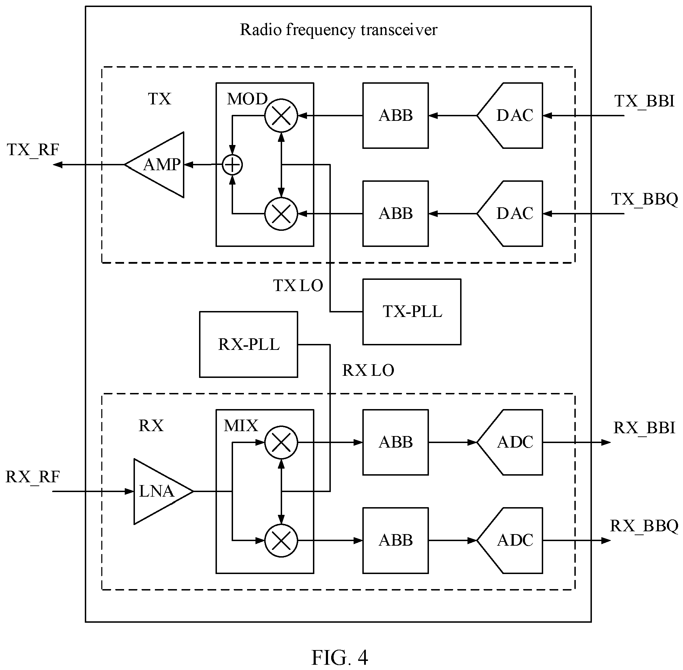

FIG. 4 is a schematic diagram of a structure of a radio frequency transceiver according to an embodiment of this application. The radio frequency transceiver includes at least one transmitter (transmitter, TX) and at least one receiver (receiver, RX), which are respectively configured to transmit and receive signals. In FIG. 4, an example in which the radio frequency transceiver includes one transmitter and one receiver is used for description.

In a transmitting direction, when the transmitter receives digital baseband data TX_BBI and TX BBQ, a digital-to-analog converter (digital-to-analog converter, DAC) converts the digital baseband data into an analog baseband signal. An analog baseband processor (analog baseband processor, ABB) processes the analog baseband signal to filter out noise in the analog baseband signal. The noise may include an image signal introduced by digital-to-analog conversion and quantization noise introduced by the DAC. A radio frequency modulator (modulator, MOD) performs frequency mixing processing on a filtered analog baseband signal, to convert the analog baseband signal into a radio frequency signal TX_RF. After being amplified by a component such as an amplifier (amplifier, AMP), the radio frequency signal TX_RF can be output to an antenna at specific power, and radiated to free space through the antenna.

In a receiving direction, a radio frequency signal RX_RF received by the antenna is processed by front-end components such as a filter and a duplexer, and then enters a radio frequency receiver. A low noise amplifier (low noise amplifier, LNA) in the radio frequency receiver amplifies the radio frequency signal RX_RF. A mixer (mixer, MIX) performs frequency mixing processing on an amplified radio frequency signal to convert the radio frequency signal into an analog baseband signal. The ABB performs low-pass filtering processing on the analog baseband signal to suppress out-of-band interference or noise and prevent sampling aliasing of an analog-to-digital converter (analog-to-digital converter, ADC) from deteriorating a signal-to-noise ratio. The ABB may further provide a specific adjustable gain, to adjust an amplitude of the analog baseband signal, so as to obtain signal strength expected by an input end of the ADC. The ADC converts the analog baseband signal into a digital baseband signal and transmits the digital baseband signal to a digital signal processing module for further processing.

During processing of the transmitter and the receiver, frequency mixing processing needs to be performed. In the transmitter, the radio frequency modulator MOD performs frequency mixing on a received analog baseband signal and a local oscillator signal TX LO generated by a transmit phase-locked loop (transmit phase-locked loop, TX-PLL), to convert the analog baseband signal into a radio frequency signal. In the receiver, the mixer (MIX) performs frequency mixing on a received radio frequency signal and a local oscillator signal RX LO generated by a receive phase-locked loop (receive phase-locked loop, RX-PLL), to convert the radio frequency signal into an analog baseband signal.

Impact of the radio frequency transceiver on a channel characteristic may be represented by a transmission function. In the transmitter direction, an ideal transmitter satisfies the following formula (1-1), where Re{ } is a real number taking function, that is, a real part taking operation is performed on a complex value; $A_{TX}$ represents a gain of the transmitter, that is, an amplitude of signal strength adjustment performed by the transmitter; $S_{TX\_BB}$ represents a digital baseband signal; $S_{TX\_RF}$ represents a radio frequency signal; and $S_{TX\_LO}$ represents a local oscillator signal of the transmitter.

$$S_{TX\_RF} = A_{TX} \cdot Re\{S_{TX\_BB} \cdot S_{TX\_LO}\} \quad (1\text{-}1)$$

Herein, $S_{TX\_BB}$ is represented as the following formula (1-2) by using a complex number signal, and is represented as the following formula (1-3) by using polar coordinates; and $S_{TX\_LO}$ is a complex single-tone signal, and satisfies a formula (1-4). In the formula, $A_{TX\_BB}(t)$ represents an amplitude of an analog baseband signal, $\theta_{TX\_BB}(t)$ represents a phase of the analog baseband signal, $\omega_C$ represents an angular frequency of the local oscillator signal, and $\varphi_{TX\_LO}$ represents a phase of the local oscillator signal.

$$S_{TX\_BB}(t) = S_{TX\_BBI}(t) + j \cdot S_{TX\_BBQ}(t) \quad (1\text{-}2)$$

$$S_{TX\_BB} = A_{TX\_BB}(t) \cdot e^{j \cdot \theta_{TX\_BB}(t)} \quad (1\text{-}3)$$

$$S_{TX\_LO} = e^{j \cdot (\omega_C t + \varphi_{TX\_LO})} \quad (1\text{-}4)$$

An ideal local oscillator signal is a complex single-tone signal, and an initial phase of the local oscillator signal does not change with time. Therefore, signal processing of the transmitter may be represented as the following formula (5):

$$S_{TX\_RF} = A_{TX} \cdot Re\{A_{TX\_BB}(t) \cdot e^{j \cdot \theta_{TX\_BB}(t)} \cdot e^{j \cdot (\omega_c t + \varphi_{TX\_LO})}\}$$

$$= A_{TX} \cdot Re\{A_{TX\_BB}(t) \cdot e^{j(\omega_c t + \theta_{TX\_BB}(t) + \varphi_{TX\_LO})}\} \quad (1\text{-}5)$$

It may be learned, according to the formula (1-5), that after the analog baseband signal is processed by the transmitter, a frequency is shifted to a position of the carrier frequency $\omega_C$. At the same time, the amplitude and phase of the signal are also adjusted by the transmitter. If processing for only a wanted signal is considered, and the operation of shifting the carrier frequency is removed, the processing for the wanted signal $S'_{TX\_RF}$ by the ideal transmitter may be represented as a formula (1-6), where $H_{TX}$ satisfies a formula (1-7).

$$S'_{TX\_RF} = S_{TX\_BB} \cdot H_{TX} \quad (1\text{-}6)$$

$$H_{TX} = A_{TX} \cdot e^{j\varphi_{TX\_LO}} \quad (1\text{-}7)$$

The foregoing $H_{TX}$ may be referred to as an equivalent transfer function of the transmitter, and can reflect impact of the transmitter on the signal, that is, a change of the amplitude and phase of the signal. According to the formula (1-7), it can be learned that an initial phase of the local oscillator signal (TX LO) of the transmitter is a main source of the impact of the transmitter on the signal phase.

Similar to signal processing of the transmitter, in the receiver direction, signal processing performed by the receiver may be represented by an equivalent transfer function $H_{RX}$ of the receiver, where $H_{RX}$ satisfies a formula (1-8).

$$H_{RX} = A_{RX} \cdot e^{j\varphi_{RX\_LO}} \quad (1\text{-}8)$$

Similar to the equivalent transfer function $H_{TX}$ of the transmitter, in the formula (1-8), $A_{RX}$ represents processing of the receiver on an amplitude of a received signal, $\varphi_{RX\_LO}$ represents processing of the receiver on a phase of the received signal, and $\varphi_{RX\_LO}$ is an initial phase of the local oscillator signal (RX LO) of the receiver. According to the formula (1-8), it can be learned that the initial phase of the local oscillator signal of the receiver is a main source of impact of the receiver on the signal phase.

Therefore, in the foregoing discontinuous working scenario, channels of the communication device are required to be consistent. For the radio frequency transceiver, it is required that at any time point, the equivalent transfer function of the transmitter or the equivalent transfer function of the receiver that represents a characteristic of the radio frequency transceiver does not change, that is, a signal processing characteristic of the radio frequency transceiver does not change. Based on this, for a discontinuous working scenario in a cellular communication system, embodiments of this application provide a phase-locked loop, a radio frequency transceiver, and a communication device, to ensure that an initial phase of a local oscillator signal remains unchanged in a valid communication time period, thereby ensuring that an equivalent transfer function of a transmitter or a receiver does not change, that is, maintaining consistency of channel characteristics provided by the radio frequency transceiver.

The phase-locked loop provided in embodiments of this application has a first working mode and a second working mode. When working in the first working mode, the phase-locked loop is configured to output a local oscillator signal. When working in the second working mode, the phase-locked loop is configured to maintain an initial phase of the local oscillator signal and does not output the local oscillator signal. The first working mode may be referred to as a normal working mode, and the second working mode may be referred to as an idle state or a phase holding mode.

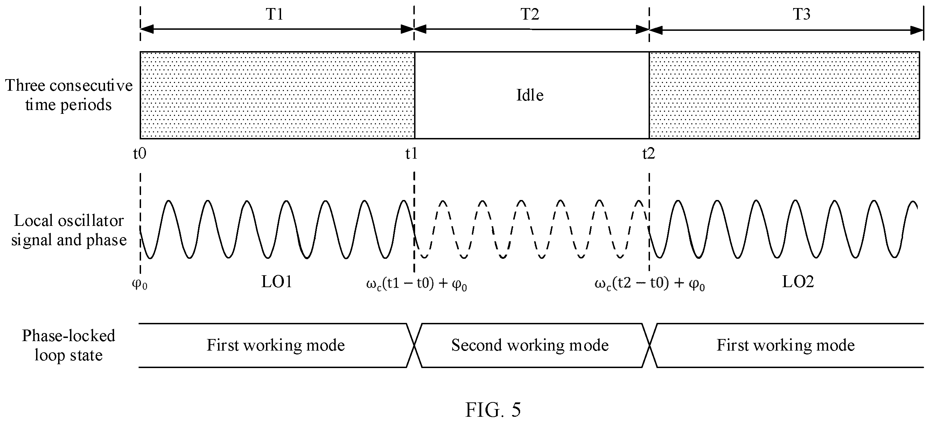

A working process of the phase-locked loop in three consecutive time periods in sequence is used as an example to describe the phase-locked loop. As shown in FIG. 5, the three consecutive time periods in sequence include a first time period T1, a second time period T2, and a third time period 53. The phase-locked loop is configured to: output a first local oscillator signal LO1 in the first time period T1, where a phase of the first local oscillator signal LO1 at an end moment of the first time period T1 is a first phase; and disable the first local oscillator signal LO1 in the second time period T2, that is, be in an idle state or not output a local oscillator signal in the second time period T2; and output a second local oscillator signal LO2 in the third time period T3. An angular frequency of the second local oscillator signal LO2 is the same as that of the first local oscillator signal LO1, a phase of the second local oscillator signal LO2 at a start moment of the third time period T3 is a second phase, a phase difference between the second phase and the first phase is equal to a product of the angular frequency and a time difference, and the time difference is a difference between the start moment of the third time period T3 and the end moment of the first time period T1. That is, the phase-locked loop works in the first working mode in the first time period T1 and the second time period T2, and works in the second working mode in the second time period T2.

As shown in FIG. 5, if a start moment of the first time period T1 is represented as t0, the end moment of the first time period T1 is represented as t1, the start moment of the third time period T3 is represented as t2, and an instantaneous phase of the first local oscillator signal LO1 at the moment t0 is $\varphi_0$ (that is, an initial phase of the first local oscillator signal LO1 is $\varphi_0$), an instantaneous phase of the first local oscillator signal LO1 at any moment satisfies the following formula (2-1), where $\omega_C$ represents the angular frequency of the first local oscillator signal LO1. Therefore, an instantaneous phase of the first local oscillator signal LO1 at the moment t1 is $\varphi_1$ and satisfies a formula (2-2), and an instantaneous phase of the first local oscillator signal LO1 at the moment t2 is $\varphi_2$ and satisfies a formula (2-3). Therefore, it is ensured that an instantaneous phase of the second local oscillator signal LO2 at the moment t2 is $\varphi_2$, that is, a phase difference between the second phase of the second local oscillator signal LO2 and the first phase of the first local oscillator signal LO1 is equal to a product of $\omega_C$ and (t2-t1).

$$\varphi = \omega_c(t - t0) + \varphi_0 \quad (2\text{-}1)$$

$$\varphi_1 = \omega_c(t1 - t0) + \varphi_0 \quad (2\text{-}2)$$

$$\varphi_2 = \omega_c(t2 - t0) + \varphi_0 \quad (2\text{-}3)$$

It should be noted that a value range of the phase difference may be 0 to $2\pi$ ($2\pi$=360°). When the product of $\omega_C$ and (t2-t1) is greater than $2\pi$, the product may be represented as $2\pi N + \Delta\varphi$, where N is an integer. In this case, $\Delta\varphi$ may be considered as the phase difference between the second phase and the first phase. For example, when the product of $\omega_C$ and (t2-t1) is 400° (that is, $2\pi$+40°), the phase difference between the second phase and the first phase may be considered as 40°.

Optionally, time intervals of the three time periods may be one or more timeslots or short timeslots. For example, the time intervals of the three time periods may be all timeslots, or the time intervals of the three time periods are all short timeslots, or a time interval of one or two of the three time periods is a timeslot, and a time interval of another time period is a short timeslot. The timeslot may include different quantities of symbols, and the short timeslot may also include different quantities of symbols. For example, one timeslot may include 14 symbols or 12 symbols, and one short timeslot includes seven symbols, six symbols, or two symbols. Quantities of symbols included in any two of the foregoing three time periods may be the same or may be different. A quantity of symbols included in a timeslot and a quantity of symbols included in a short timeslot are not specifically limited in embodiments of this application.

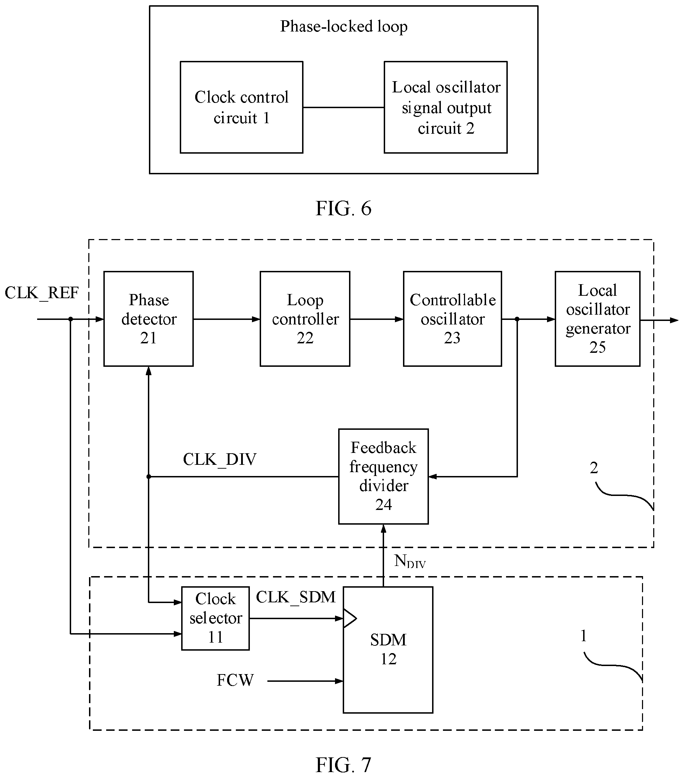

Specifically, as shown in FIG. 6, the phase-locked loop includes a clock control circuit 1 and a local oscillator signal output circuit 2. The clock control circuit 1 is configured to receive a reference clock CLK_REF and a feedback clock CLK_DIV and output a frequency control word NDIV The feedback clock is configured to feed back a clock of the first local oscillator signal in the first time period, and feed back a clock of the second local oscillator signal in the third time period. The local oscillator signal output circuit 2 is configured to separately output the first local oscillator signal and the second local oscillator signal based on the frequency control word NDIV and the reference clock CLK_REF in the first time period and the third time period, and the local oscillator signal output circuit 2 does not work in the second time period.

In embodiments of this application, for the first time period, the second time period, and the third time period that are consecutive in sequence, the phase-locked loop can output the first local oscillator signal in the first time period, and output the second local oscillator signal in the third time period. The phase difference between the second phase of the second local oscillator signal and the first phase of the first local oscillator signal is equal to the product of the angular frequency and the time difference, to ensure that an initial phase of a local oscillator signal output by the phase-locked loop in a discontinuous time period remains unchanged. In addition, when the phase-locked loop is in an idle state in the second time period, the phase-locked loop does not output a local oscillator signal, so that power consumption can be reduced, and power consumption of the communication device can be reduced when the phase-locked loop is used in the communication device.

Further, as shown in FIG. 7, the local oscillator signal output circuit 2 includes: a phase detector (phase detector, PD) 21, a loop controller (loop controller, LCT) 22, and a controllable oscillator (controllable oscillator, OSC) 23 that are sequentially coupled in series between a first node and a second node, and a feedback frequency divider (frequency divider) 24 that is coupled between the first node and the second node. The first node is coupled to an input end of the local oscillator signal output circuit 2, and the second node is coupled to an output end of the local oscillator signal output circuit 2. Optionally, the local oscillator signal output circuit 2 may further include a local oscillator generator (local oscillator generator, LOG) 25 coupled between the second node and the output end.

The phase detector 21 is configured to: detect a phase difference between the reference clock CLK_REF and the feedback clock CLK DIV, and output a detection signal based on the phase difference. The detection signal may be a voltage signal or a current signal. Assuming that a phase of the reference clock CLK_REF is $\theta_{REF}(t)$, a phase of the feedback clock is $\theta_{DIV}(t)$, and a conversion gain of the phase detector 21 is $K_{PD}$, a detection signal $E_{PD}(t)$ output by the phase detector 21 satisfies the following formula (2-4).

$$E_{PD}(t) = K_{PD} \cdot [\theta_{REF}(t) - \theta_{DIV}(t)] \quad (2\text{-}4)$$

The loop controller 22 may also be referred to as a loop filter (loop filter), and is configured to output a control signal based on the detection signal output by the phase detector 21, and the detection signal may be a voltage signal. A type of the loop controller 22 may include a proportional controller (proportional controller) or a proportional-integral controller (proportional-integral controller). Assuming that the type of the loop controller 22 is a proportion-integral controller, a control signal $V_{CTRL}(t)$ output by the loop controller 22 satisfies the following formula (2-5), where $K_I$ and $K_P$ are respectively a proportional gain and an integral gain of the loop controller 22.

$$V_{CTRL}(t) = K_I \cdot E_{PD}(t) + K_P \cdot \int_0^t E_{PD}(\tau) \cdot d\tau \quad (2\text{-}5)$$

The controllable oscillator 23 is configured to output a local oscillator signal based on the control signal output by the loop controller 22. The local oscillator signal output by the controllable oscillator 23 may be directly used as a local oscillator signal (for example, the first local oscillator signal or a third local oscillator signal) of the phase-locked loop, or a parameter such as a frequency or an amplitude of the local oscillator signal may be processed and then a processed local oscillator signal is used as a local oscillator signal of the phase-locked loop. Assuming that the control signal output by the loop controller 22 is $V_{CTRL}(t)$, and a conversion gain of the controllable oscillator 23 is $K_V$, the local oscillator signal $f_{OSC}(t)$ output by the controllable oscillator 23 satisfies the following formula (2-6), where $f_0$ represents a frequency of the control signal when $V_{CTRL} = 0$.

$$f_{OSC}(t) = f_0 + K_V \cdot V_{CTRL}(t) \quad (2\text{-}6)$$

The feedback frequency divider 24 is configured to perform, based on a first frequency control word, frequency division processing on the local oscillator signal output by the controllable oscillator 23, to output the feedback clock CLK_DIV. The first frequency control word may also be referred to as a frequency division ratio. Assuming that the frequency division ratio is $N_{DIV}$, a frequency $f_{DIV}(t)$ of the feedback clock CLK_DIV and a frequency $f_{OSC}(t)$ of the local oscillator signal output by the controllable oscillator 23 satisfy the following formula (2-7).

$$f_{DIV}(t) = \frac{f_{OSC}(t)}{N_{DIV}} \quad (2\text{-}7)$$

The local oscillator generator 25 is configured to further process a local oscillator signal output by the feedback frequency divider 24. For example, the processing may include frequency division processing, frequency multiplication processing, orthogonal processing, or the like. This is not specifically limited in embodiments of this application.

Further, as shown in FIG. 7, the clock control circuit 1 includes a clock selector (clock multiplexer, CMUX) 11 and a Sigam-Delta modulator (Sigam-Delta modulator, SDM) 12. The clock selector 11 is configured to select the feedback clock CLK_DIV in the first time period and the third time period for output to the SDM 12 (that is, select the feedback clock CLK_DIV as a working clock CLK_SDM of the SDM 12), and select the reference clock CLK_REF in the second time period for output to the SDM 12 (that is, select the CLK_REF as a working clock CLK_SDM of the SDM 12). The SDM 12 is configured to output a frequency division ratio $N_{DIV}$ based on a second frequency control word (frequency control word, FCW) and the feedback clock CLK_DIV in the first time period and the third time period, and output a frequency division ratio $N_{DIV}$ based on the second frequency control word and the reference clock CLK_REF in the second time period.

The phase-locked loop may be a fractional frequency-division phase-locked loop, and the SDM 12 is configured to implement a fractional frequency-division function of the phase-locked loop. Assuming that a frequency of the first local oscillator signal or the third local oscillator signal is $f_{LO}$, a frequency of the reference clock CLK_REF is $f_{REF}$, and the second frequency control word is $N_{FCW}$, $N_{FCW}$ satisfies the following formula (2-8). If $N_{FCW}$ is an integer, the phase-locked loop may not include the SDM 12, and the feedback frequency divider 24 directly implements frequency division based on the frequency division ratio $N_{DIV}$. In this case, the frequency division ratio $N_{DIV}$ is equal to $N_{FCW}$.

$$N_{FCW} = \frac{f_{OSC}}{f_{REF}} \quad (2\text{-}8)$$

If $N_{FCW}$ is a fraction, the frequency control word $N_{FCW}$ needs to be converted, by using the SDM 12, into an integer frequency division sequence that can be processed by the feedback frequency divider 24. Assuming that the second frequency control word $N_{FCW}$ satisfies a formula (2-9), and $N_{FCW\_INTG}$ and $N_{FCW\_FRAC}$ are respectively an integer part and a fractional part of $N_{FCW}$, after $N_{FCW}$ is processed by the SDM 12, a series of integer sequences whose change ranges are near $N_{FCW\_INTG}$ are output, that is, the frequency division ratio $N_{DIV}$ satisfies a formula (2-10). The change range of $N_{DIV}$ is related to a type of the SDM 12.

$$N_{FCW} = N_{FCW\_INTG} + N_{FCW\_FRAC} \quad (2\text{-}9)$$

$$N_{DIV} \in N_{FCW\_INTG} + \{\ldots, -2, -1, 0, 1, 2, \ldots\} \quad (2\text{-}10)$$

It can be learned from the formula (2-10) that, after processing performed by the SDM 12, the feedback frequency divider 24 receives an integer frequency division ratio that changes within a specific range. However, in a long time range, an average value of frequency division ratios received by the feedback frequency divider 24 is an expected second frequency control word, that is, $N_{FCW}$ satisfies a formula (2-11).

$$N_{FCW} = \text{MEAN}\{N_{DIV}[i]\} \quad (2\text{-}11)$$

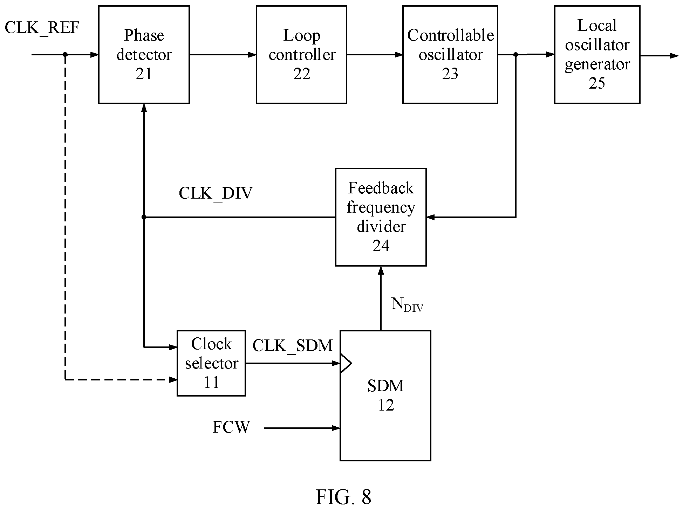

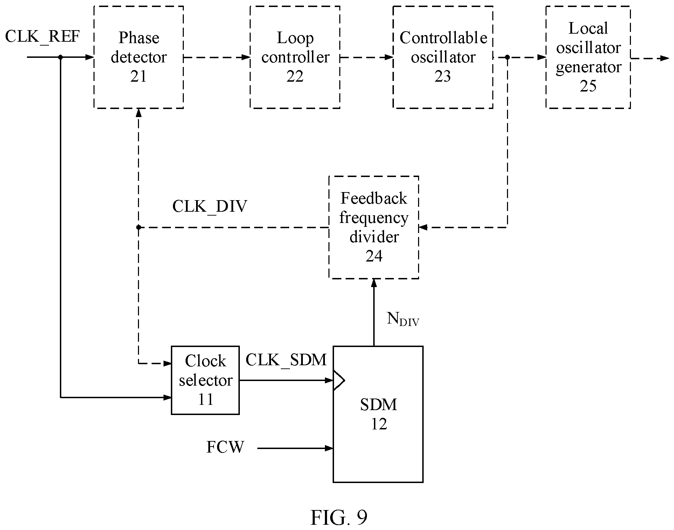

After the specific structure of the phase-locked loop is described, the following describes in detail, based on FIG. 7, working states of components in different working simulations of the phase-locked loop. FIG. 8 is a schematic diagram of a working state of each component when the phase-locked loop is in the first working mode. The phase detector 21, the loop controller 22, the controllable oscillator 23, the feedback frequency divider 24, the local oscillator generator 25, the clock selector 11, and the SDM 12 are all in the working state, and the clock selector 11 selects the feedback clock CLK_DIV for output to the SDM 12. FIG. 9 is a schematic diagram of a working state of each component when the phase-locked loop is in the second working mode. The phase detector 21, the loop controller 22, the controllable oscillator 23, the feedback frequency divider 24, and the local oscillator generator 25 are all turned off (that is, do not work), the clock selector 11 and the SDM 12 are in the working state, and the clock selector 11 selects the reference clock CLK_REF for output to the SDM 12.

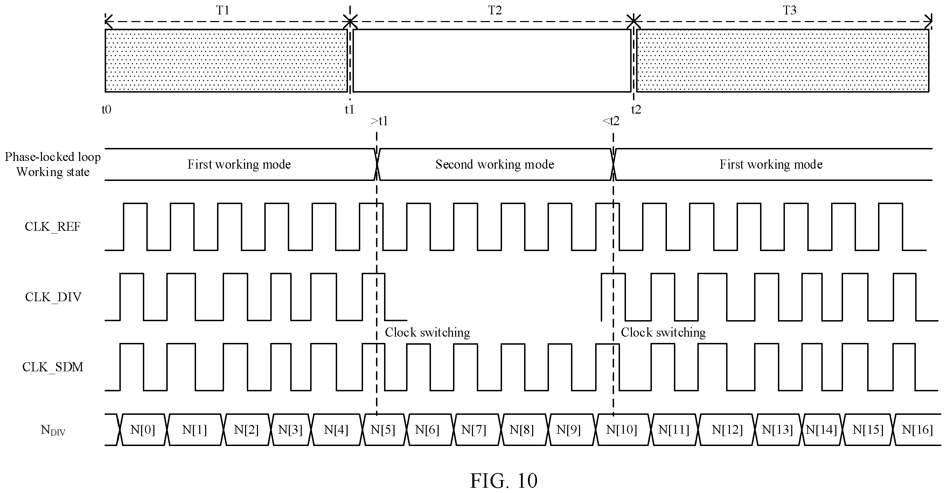

Corresponding to the working state of each component shown in FIG. 8 and FIG. 9, FIG. 10 shows a time sequence diagram of a plurality of signals involved in the phase-locked loop in different working modes. The plurality of signals include the reference clock CLK_REF, the feedback clock CLK_DIY, the clock CLK_SDM received by the SDM 12, and the frequency division ratio $N_{DIV}$. It should be noted that, in FIG. 10, three consecutive time periods in sequence are represented as T1, T2, and T3, the phase-locked loop is in the first working mode at T1 and T3, and is in the second working mode at T2. In FIG. 10, an integer sequence corresponding to the frequency division ratio $N_{DIV}$ is represented as N[0], N[1], N[2], ..., N[16]. The integer sequence is merely an example, and does not constitute a limitation on embodiments of this application.

A working state of each component in the foregoing phase-locked loop may be controlled by a processor or a controller. For example, a control process of the controller is described with reference to the time period T1 to T3 in FIG. 10 by using an example in which the controller controls the working state of each component in the phase-locked loop. Specifically, in the time period T1, the controller controls the phase detector 21, the loop controller 22, the controllable oscillator 23, the feedback frequency divider 24, the local oscillator generator 25, the clock selector 11, and the SDM 12 to be turned on, and controls the clock selector 11 to select the feedback clock CLK_DIV for output, so as to use the feedback clock CLK_DIV as the working clock of the SDM 12. In the time period T2, the clock selector 11 is controlled to select the reference clock CLK_REF for output, so as to use the reference clock CLK_REF as the working clock of the SDM 12, and after switching is completed, the controller controls the phase detector 21, the loop controller 22, the controllable oscillator 23, the feedback frequency divider 24, and the local oscillator generator 25 to be turned off. In the time period T3, the controller controls the phase detector 21, the loop controller 22, the controllable oscillator 23, the feedback frequency divider 24, the local oscillator generator 25, the clock selector 11, and the SDM 12 to be turned on, and controls the clock selector 11 to select the feedback clock CLK_DIV for output, so as to use the feedback clock CLK_DIV as the working clock of the SDM 12. In the foregoing process, the SDM 12 can continuously and stably output the frequency division ratio $N_{DIV}$, thereby ensuring that an initial phase of a local oscillator signal output by the local oscillator signal output circuit 2 in the phase-locked loop remains unchanged in a discontinuous time period.

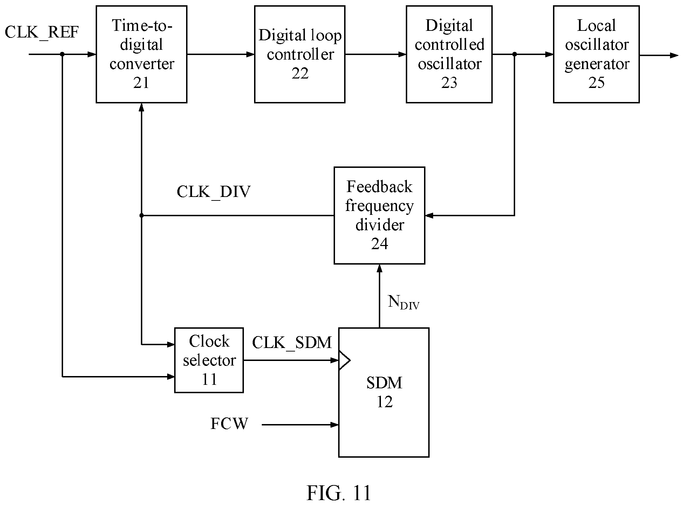

Further, the phase-locked loop is a digital phase-locked loop, and the digital phase-locked loop may be a digital fractional frequency-division phase-locked loop (digital fractional-N PLL). In the digital fractional frequency-division phase-locked loop, the phase detector 21, the loop controller 22, and the controllable oscillator 23 may be digital circuits configured to process or generate digital signals. Specifically, the phase detector 21 is a digital phase detector. For example, the digital phase detector may include a time-to-digital converter (time-to-digital converter, TDC), the loop controller 22 includes a digital loop controller, and the controllable oscillator 23 includes a digital controlled oscillator (digital controlled oscillator, DCO). In a possible embodiment, with reference to FIG. 7, as shown in FIG. 11, the digital phase-locked loop includes: a time-to-digital converter 21, a digital loop controller 22, a digital controlled oscillator 23, and a local oscillator generator 25 that are sequentially coupled in series between a first node and an output end, a feedback frequency divider 24 that is coupled between the first node and a second node, a clock selector 11, and an SDM 12.

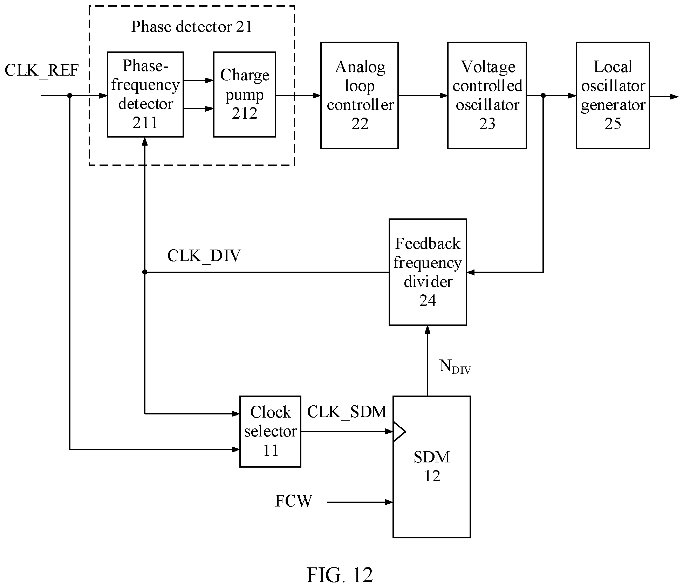

Alternatively, the phase-locked loop is an analog phase-locked loop, and the analog phase-locked loop may be an analog fractional frequency-division phase-locked loop (analogy fractional-N PLL). In the analog fractional frequency-division phase-locked loop, the phase detector 21, the loop controller 22, and the controllable oscillator 23 may be analog circuits configured to process or generate analog signals. Specifically, the phase detector 21 includes an analog phase detector. For example, the analog phase detector may include a phase-frequency detector (phase-frequency detector, PFD) and a charge pump (charge pump, CP). The loop controller 22 is an analog loop controller (analog loop controller, ALCT). The controllable oscillator 23 is a voltage controlled oscillator (voltage controlled oscillator, VCO). In a possible embodiment, with reference to FIG. 7, as shown in FIG. 12, the analog phase-locked loop includes: a phase-frequency detector 211, a charge pump 212, an analog loop controller 22, a voltage controlled oscillator 23, and a local oscillator generator 25 that are sequentially coupled in series between a first node and an output end, a feedback frequency divider 24 coupled between the first node and a second node, a clock selector 11, and an SDM 12.

It should be noted that, the specific structures of the digital phase-locked loop and the analog phase-locked loop that are shown above are merely examples, and do not constitute a limitation on the specific structures of the digital phase-locked loop and the analog phase-locked loop. For example, the digital phase detector in the digital phase-locked loop may alternatively be another digital circuit that has a same function as the time-to-digital converter, and the analog phase detector in the analog phase-locked loop may alternatively be another digital circuit that has a same function as an analog phase detector that includes a phase-frequency detector and a charge pump. This is not specifically limited in embodiments of this application.

Based on this, an embodiment of this application further provides a radio frequency transceiver. A structure of the radio frequency transceiver is shown in FIG. 4. The radio frequency transceiver includes at least one transmitter, where the transmitter includes any phase-locked loop provided above, and the phase-locked loop may be referred to as a first phase-locked loop; and/or at least one receiver, where the receiver includes any phase-locked loop provided above, and the phase-locked loop may be referred to as a second phase-locked loop. In FIG. 4, an example in which the radio frequency transceiver includes one transmitter and one receiver is used for description.

Optionally, the transmitter further includes a digital-to-analog converter, a first analog processing circuit, a radio frequency modulator, a first phase-locked loop, and an amplifier. An output end of the digital-to-analog converter is coupled to an input end of the first analog processing circuit, an output end of the first analog processing circuit and an output end of the first phase-locked loop are respectively coupled to two input ends of the radio frequency modulator, and an output end of the radio frequency modulator is coupled to an input end of the amplifier. Further, the at least one transmitter disables output of a transmission signal in a second time period.

Optionally, the receiver further includes: an analog-to-digital converter, a second analog processing circuit, a mixer, a second phase-locked loop, and a low noise amplifier. An output end of the low noise amplifier and an output end of the second phase-locked loop are coupled to two input ends of the mixer, an output end of the mixer is coupled to an input end of the second analog processing circuit, and an output end of the second analog processing circuit is coupled to an input end of the analog-to-digital converter.

It should be noted that for specific descriptions of the phase-locked loop, the transmitter, and the receiver, refer to the foregoing descriptions. Details are not described herein again in this embodiment of this application.

Further, when the at least one transmitter includes a plurality of transmitters, the plurality of transmitters may share one first phase-locked loop, or may separately include one first phase-locked loop. When the at least one receiver includes a plurality of receivers, the plurality of receivers may share one second phase-locked loop, or may separately include one second phase-locked loop. When the radio frequency transceiver includes both the transmitter and the receiver, the transmitter and the receiver may share one phase-locked loop, or may separately include different phase-locked loops. During actual application, a person skilled in the art may determine, based on an actual situation, whether to share a phase-locked loop. This is not specifically limited in this embodiment of this application.

Another aspect of this application further provides a communication device. The communication device may be a base station or a terminal device. The communication device includes a baseband circuit, a radio frequency transceiver, and an antenna that are sequentially coupled. The radio frequency transceiver is the radio frequency transceiver provided above.

Another aspect of this application further provides a local oscillator signal output method, which is applied to a phase-locked loop. The method includes: outputting a first local oscillator signal in a first time period, where a phase of the first local oscillator signal at an end moment of the first time period is a first phase; disabling the first local oscillator signal in a second time period; and outputting a second local oscillator signal in a third time period. The first time period, the second time period, and the third time period are three consecutive time periods in sequence, an angular frequency of the second local oscillator signal is the same as that of the first local oscillator signal, a phase of the second local oscillator signal at a start moment of the third time period is a second phase, a phase difference between the second phase and the first phase is equal to a product of the angular frequency and a time difference, and the time difference is a difference between the start moment of the third time period and the end moment of the first time period.

Optionally, time intervals of the first time period, the second time period, and the third time period are timeslots or short timeslots. In an example, the timeslot includes 14 symbols or 12 symbols. In another example, the short timeslot includes seven symbols, six symbols, or two symbols.

Further, the phase-locked loop includes a clock control circuit and a local oscillator signal output circuit, and the method further includes: The clock control circuit outputs a frequency control word based on a reference clock and a feedback clock. The feedback clock is configured to separately feed back the first local oscillator signal and the second local oscillator signal. The local oscillator signal output circuit outputs the first local oscillator signal and the second local oscillator signal based on the frequency control word and the reference clock. The local oscillator signal output circuit does not work in the second time period.

Further, the clock control circuit includes a clock selector and a Sigam-Delta modulator.

Correspondingly, that the clock control circuit outputs a frequency control word based on a reference clock and a feedback clock includes: The clock selector selects one of the feedback clock and the reference clock for output to the Sigam-Delta modulator. The Sigam-Delta modulator outputs the frequency control word based on the feedback clock and the reference clock.

It should be noted that for specific descriptions of each of the foregoing steps, refer to the foregoing related descriptions. Details are not described herein again in this embodiment of this application.

In this embodiment of this application, for the first time period, the second time period, and the third time period that are consecutive in sequence, the phase-locked loop can output the first local oscillator signal in the first time period, and output the second local oscillator signal in the third time period. The phase difference between the second phase of the second local oscillator signal and the first phase of the first local oscillator signal is equal to the product of the angular frequency and the time difference, to ensure that an initial phase of a local oscillator signal output by the phase-locked loop in a discontinuous time period remains unchanged. In addition, when the phase-locked loop is in an idle state in the second time period, the phase-locked loop does not output a local oscillator signal, so that power consumption can be reduced, and power consumption of a communication device can be reduced when the phase-locked loop is used in the communication device.

In the several embodiments provided in this application, it should be understood that the disclosed different circuits and units may be implemented in other manners. For example, the described apparatus embodiments are merely examples. For example, division of the circuits or units is merely logical function division, and may be other division during actual implementation. For example, a plurality of units or components may be combined or may be integrated into another apparatus, or some features may be ignored or not performed.

The units described as separate components may or may not be physically separate, and components displayed as units may be one or more physical units, that is, may be located in one place, or may be distributed on a plurality of different places. Some or all of the units may be selected depending on actual requirements to achieve the objectives of the solutions in embodiments.

In addition, function units in embodiments of this application may be integrated into one processing unit, or each of the units may exist alone physically, or two or more units may be integrated into one unit. The integrated unit may be implemented in a form of hardware, or may be implemented in a form of a software function unit.

It should be finally noted that the foregoing descriptions are merely specific implementations of this application. However, the protection scope of this application is not limited thereto. Any variation or replacement within the technical scope disclosed in this application shall fall within the protection scope of this application. Therefore, the protection scope of this application shall be subject to the protection scope of the claims.

**Claims**

1. A phase-locked loop, wherein the phase-locked loop is configured to:

   output a first local oscillator signal in a first time period, wherein a phase of the first local oscillator signal at an end moment of the first time period is a first phase;
   disable the first local oscillator signal in a second time period; and
   output a second local oscillator signal in a third time period, wherein the first time period, the second time period, and the third time period are three consecutive time periods in sequence, an angular frequency of the second local oscillator signal is the same as that of the first local oscillator signal, a phase of the second local oscillator signal at a start moment of the third time period is a second phase, a phase difference between the second phase and the first phase is equal to a product of the angular frequency and a time difference, and the time difference is a difference between the start moment of the third time period and the end moment of the first time period.

2. The phase-locked loop according to claim 1, wherein time intervals of the first time period, the second time period, and the third time period are one or more timeslots or short timeslots.

3. The phase-locked loop according to claim 2, wherein the timeslot comprises 14 symbols or 12 symbols.

4. The phase-locked loop according to claim 2, wherein the short timeslot comprises seven symbols, six symbols, or two symbols.

5. The phase-locked loop according to any one of claims 1 to 4, wherein the phase-locked loop comprises a clock control circuit and a local oscillator signal output circuit;

   the clock control circuit is configured to output the frequency control word based on a reference clock and a feedback clock, wherein the feedback clock is configured to separately feed back the first local oscillator signal and the second local oscillator signal;
   the local oscillator signal output circuit is configured to separately output the first local oscillator signal and the second local oscillator signal based on the frequency control word and the reference clock; and
   the local oscillator signal output circuit does not work in the second time period.

6. The phase-locked loop according to claim 5, wherein the clock control circuit comprises a clock selector and a Sigam-Delta modulator;

   the clock selector is configured to select one of the feedback clock and the reference clock for output to the Sigam-Delta modulator; and
   the Sigam-Delta modulator is configured to output the frequency control word based on the feedback clock and the reference clock.

7. The phase-locked loop according to claim 5 or 6, wherein the local oscillator signal output circuit comprises:

   a phase detector, a loop controller, and a controllable oscillator that are sequentially coupled in series between a first node and a second node, and a feedback frequency divider that is coupled between the first node and the second node; and
   the first node is coupled to an input end of the local oscillator signal output circuit, and the second node is coupled to an output end of the local oscillator signal output circuit.

8. The phase-locked loop according to claim 7, wherein the phase-locked loop is a digital phase-locked loop.

9. The phase-locked loop according to claim 8, wherein the phase detector comprises a time-to-digital converter, the loop controller comprises a digital loop controller, and the controllable oscillator comprises a digital controlled oscillator.

10. The phase-locked loop according to claim 7, wherein the phase-locked loop is an analog phase-locked loop.

11. The phase-locked loop according to claim 10, wherein the phase detector comprises a phase-frequency detector and a charge pump, the loop controller comprises an analog loop controller, and the controllable oscillator comprises a voltage controlled oscillator.

12. The phase-locked loop according to any one of claims 7 to 11, wherein the local oscillator signal output circuit further comprises a local oscillator generator coupled between the second node and the output end.

13. A radio frequency transceiver, wherein the radio frequency transceiver comprises:

a transmitter, wherein the transmitter comprises a digital-to-analog converter, a first analog processing circuit, a radio frequency modulator, a first phase-locked loop, and an amplifier, wherein an output end of the digital-to-analog converter is coupled to an input end of the first analog processing circuit, an output end of the first analog processing circuit and an output end of the first phase-locked loop are respectively coupled to two input ends of the radio frequency modulator, and an output end of the radio frequency modulator is coupled to an input end of the amplifier; and
the first phase-locked loop is the phase-locked loop according to any one of claims 1 to 12.

14. The radio frequency transceiver according to claim 13, wherein the transmitter transmits a signal in the first time period and the third time period, and disables signal transmission in the second time period.

15. The radio frequency transceiver according to claim 13 or 14, wherein the radio frequency transceiver further comprises:

a receiver, wherein the receiver comprises: an analog-to-digital converter, a second analog processing circuit, a mixer, a second phase-locked loop, and a low noise amplifier, wherein an output end of the low noise amplifier and an output end of the second phase-locked loop are coupled to two input ends of the mixer, an output end of the mixer is coupled to an input end of the second analog processing circuit, and an output end of the second analog processing circuit is coupled to an input end of the analog-to-digital converter; and
the second phase-locked loop is the phase-locked loop according to any one of claims 1 to 12.

16. A communication device, wherein the communication device comprises a baseband circuit, a radio frequency transceiver, and an antenna that are sequentially coupled, and the radio frequency transceiver is the radio frequency transceiver according to any one of claims 13 to 15.

17. A local oscillator signal output method, wherein the method comprises:

outputting a first local oscillator signal in a first time period, wherein a phase of the first local oscillator signal at an end moment of the first time period is a first phase;
disabling the first local oscillator signal in a second time period; and
outputting a second local oscillator signal in a third time period, wherein the first time period, the second time period, and the third time period are three consecutive time periods in sequence, an angular frequency of the second local oscillator signal is the same as that of the first local oscillator signal, a phase of the second local oscillator signal at a start moment of the third time period is a second phase, a phase difference between the second phase and the first phase is equal to a product of the angular frequency and a time difference, and the time difference is a difference between the start moment of the third time period and the end moment of the first time period.

18. The method according to claim 17, wherein time intervals of the first time period, the second time period, and the third time period are one or more timeslots or short timeslots.

19. The method according to claim 18, wherein the timeslot comprises 14 symbols or 12 symbols.

20. The method according to claim 18, wherein the short timeslot comprises seven symbols, six symbols, or two symbols.

21. The method according to any one of claims 17 to 20, wherein the phase-locked loop comprises a clock control circuit and a local oscillator signal output circuit, and the method further comprises:

outputting, by the clock control circuit, a frequency control word based on the reference clock and a feedback clock, wherein the feedback clock is configured to separately feed back the first local oscillator signal and the second local oscillator signal; and

separately outputting, by the local oscillator signal output circuit, the first local oscillator signal and the second local oscillator signal based on the frequency control word and the reference clock, wherein the local oscillator signal output circuit does not work in the second time period.

22. The method according to claim 21, wherein the clock control circuit comprises a clock selector and a Sigam-Delta modulator, and the outputting, by the clock control circuit, a frequency control word based on the reference clock and a feedback clock comprises:

selecting, by the clock selector, one of the feedback clock and the reference clock for output to the Sigam-Delta modulator; and

outputting, by the Sigam-Delta modulator, the frequency control word based on the feedback clock and the reference clock.

Three consecutive timeslots

| TS1 | TS2 | TS3 |
|-----|-----|-----|
| | Idle | |

LO

Phase-locked loop state

| Working state | Working state | Working state |

FIG. 1

| TS1 | TS2 |
|-----|-----|

S1 to S7   S8 to S14   S1 to S7   S8 to S14

FIG. 2

| TS1 | TS2 | TS3 |
|-----|-----|-----|

DMRS   Idle

FIG. 3

FIG. 4

FIG. 5

Phase-locked loop

| Clock control circuit 1 | Local oscillator signal output circuit 2 |

FIG. 6

CLK_REF

| Phase detector 21 | Loop controller 22 | Controllable oscillator 23 | Local oscillator generator 25 |

CLK_DIV

| Feedback frequency divider 24 |

2

$N_{DIV}$

| Clock selector 11 | CLK_SDM | SDM 12 |

FCW

1

FIG. 7

FIG. 8

CLK_REF

| Phase detector 21 | Loop controller 22 | Controllable oscillator 23 | Local oscillator generator 25 |

CLK_DIV

Feedback frequency divider 24

$N_{DIV}$

Clock selector 11

CLK_SDM

SDM 12

FCW

FIG. 9

FIG. 10

FIG. 11

FIG. 12

## INTERNATIONAL SEARCH REPORT

| | International application No. |
|---|---|
| | **PCT/CN2021/134619** |

| A. | CLASSIFICATION OF SUBJECT MATTER |
|---|---|

H03L 7/00(2006.01)i;  H04W 52/00(2009.01)i

According to International Patent Classification (IPC) or to both national classification and IPC

| B. | FIELDS SEARCHED |
|---|---|

Minimum documentation searched (classification system followed by classification symbols)

H03L; H04W

Documentation searched other than minimum documentation to the extent that such documents are included in the fields searched

Electronic data base consulted during the international search (name of data base and, where practicable, search terms used)

CNABS; CNTXT; WOTXT; EPTXT; USTXT; VEN; 3GPP; IEEE: 锁相环, 本振, 非连续, 不连续, 空闲, 待机, 睡眠, 休眠, 唤醒, 激活, 相位, 差, 偏移, 时间, 时长, 时段, PLL, local oscillator, LO, DRX, idle, sleep+, wake 1w up, activat+, phase, difference, shift, offset, time, period

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 105075110 A (QUALCOMM INC.) 18 November 2015 (2015-11-18) description, paragraphs 0030-0077, and figures 1-5 | 1-4, 13-20 |
| X | US 8643414 B1 (RAMBUS INC.) 04 February 2014 (2014-02-04) description, column 1, lines 21-39 | 1-4, 13-20 |
| A | US 2013182599 A1 (TELEFONAKTIEBOLAGET LM ERICSSON (PUBL)) 18 July 2013 (2013-07-18) entire document | 1-22 |
| A | US 2020021295 A1 (QUALCOMM INC.) 16 January 2020 (2020-01-16) entire document | 1-22 |
| A | CN 113497622 A (TOSHIBA K.K. et al.) 12 October 2021 (2021-10-12) entire document | 1-22 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **28 June 2022** | **24 August 2022** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2021/134619**

| Patent document cited in search report | | | Publication date (day/month/year) | Patent family member(s) | | | Publication date (day/month/year) |
|---|---|---|---|---|---|---|---|
| CN | 105075110 | A | 18 November 2015 | US | 2014270032 | A1 | 18 September 2014 |
| | | | | WO | 2014159083 | A1 | 02 October 2014 |
| | | | | KR | 20150128761 | A | 18 November 2015 |
| | | | | EP | 2973998 | A1 | 20 January 2016 |
| | | | | JP | 2016512412 | W | 25 April 2016 |
| | | | | US | 9344270 | B2 | 17 May 2016 |
| | | | | IN | 201504661 | P4 | 01 July 2016 |
| | | | | EP | 2973998 | B1 | 10 May 2017 |
| | | | | CN | 105075110 | B | 06 July 2018 |
| | | | | JP | 6396412 | B2 | 26 September 2018 |
| | | | | KR | 102219763 | B1 | 23 February 2021 |
| US | 8643414 | B1 | 04 February 2014 | None | | | |
| US | 2013182599 | A1 | 18 July 2013 | WO | 2012041337 | A1 | 05 April 2012 |
| | | | | EP | 2622808 | A1 | 07 August 2013 |
| | | | | US | 8908555 | B2 | 09 December 2014 |
| | | | | EP | 2622808 | B1 | 09 May 2018 |
| | | | | IN | 372070 | B | 23 July 2021 |
| | | | | IN | 201301082 | P2 | 07 March 2014 |
| US | 2020021295 | A1 | 16 January 2020 | TW | 202007088 | A | 01 February 2020 |
| | | | | WO | 2020013917 | A1 | 16 January 2020 |
| | | | | US | 10727838 | B2 | 28 July 2020 |
| CN | 113497622 | A | 12 October 2021 | JP | 2021150844 | A | 27 September 2021 |
| | | | | US | 2022166437 | A1 | 26 May 2022 |
| | | | | US | 11277139 | B2 | 15 March 2022 |
| | | | | US | 2021297083 | A1 | 23 September 2021 |

Form PCT/ISA/210 (patent family annex) (January 2015)